# EUROPEAN PATENT SPECIFICATION

(11) **EP 0 296 725 B1**
(45) Date of publication and mention of the grant of the patent: **18.05.1994**
(21) Application number: 88305014.8
(22) Date of filing: 01.06.1988
(51) Int. Cl.: H01L 31/10, H01L 27/14, H01L 27/06

(54) **Photosensors**
Photodetektoren
Photosenseurs

(30) Priority: 25.06.1987 JP 159122/87
(43) Date of publication of application: 28.12.1988
(73) Proprietor: SONY CORPORATION, Tokyo 141 (JP)
(72) Inventor: Maekawa, Toshikazu Patents Division, Shinagawa-ku Tokyo 141 (JP)
(74) Representative: Thomas, Christopher Hugo

(56) References cited:
- EP-A- 0 162 307
- PATENT ABSTRACTS OF JAPAN, vol. 9, no. 35 (E-295)(1758), 14 February 1985 ; & JP-A-59177964
- PATENT ABSTRACTS OF JAPAN, vol. 10, no. 379 (E-465)(2436), 18 December 1986 ; & JP-A-61172367
- S.M. Sze, Physics of Semiconductor Devices, John Wiley & Sons, 1981, pp. 754, 755.

## Description

This invention relates to photosensors comprising a PIN photodiode.

There has been previously proposed a photosensor as shown in Figure 1, formed of a P type semiconductor layer b spaced from an N type semiconductor layer c on a transparent insulating layer a such as of quartz. An intrinsic (I) amorphous semiconductor layer d is deposited between the layer b and the layer c so as to provide a lateral PIN photodiode PD which serves as a light receiving element. Figure 2 shows an equivalent circuit diagram of the photodiode PD. The photodiode PD comprises a photo detecting circuit with a MOS transistor Q serially connected therewith, as shown in Figure 3. A symbol φ designates a switching pulse for switching the transistor Q, and C_{H} represents an equivalent reverse bias capacitance of the photodiode PD.

The photodiode PD can be made in a manufacturing process for a PIN photodiode of sandwich construction formed of a P type semiconductor layer, an intrinsic (I) amorphous semiconductor layer and an N type semiconductor layer. This is a relatively simple manufacturing process, using a relatively simple photo mask pattern, but the reverse bias capacitance C_{H} is small, which results in a narrow dynamic range and an undesirable signal holding characteristic.

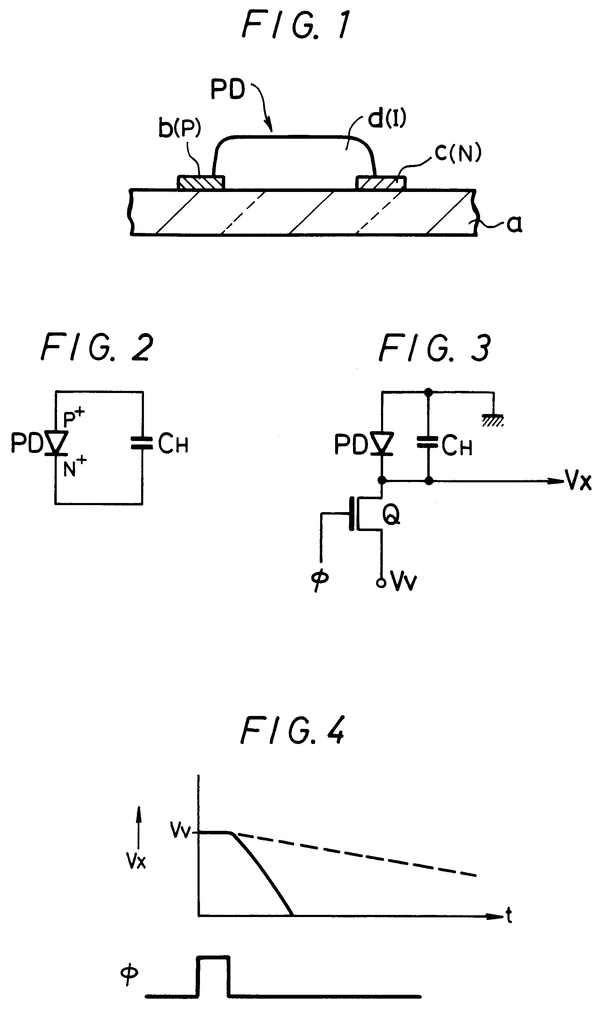

Due to the difference in construction between an ordinary sandwich PIN photodiode and a lateral PIN photodiode, the reverse bias capacitance C_{H} of the lateral PIN is always extremely small, for example 1/20 or less than that of the sandwich PIN photodiode. This problem will be explained in detail with reference to Figure 4, which is a characteristic graph showing the output voltage of the photo detector circuit of Figure 3 in a dark field, specifically, the change in the output voltage of the photo detector circuit when the transistor Q is turned off by the switching pulse φ. The abcsissa represents time t.

As is apparent from Figure 4, with this photosensor which employs a lateral PIN photodiode as a light receiving element, if the switching pulse φ falls as shown by the solid line, the output voltage Vx which is at substantially the same level as a source voltage Vv will abruptly decrease to earth level. On the other hand, with a sandwich PIN photodiode of the same size as the lateral PIN photodiode, the output voltage Vx slowly decreases from the source voltage level to earth level as shown by the dashed line. This difference results due to the differences in the reverse bias capacitances between the sandwich and lateral PIN photodiodes. Specifically, the lateral PIN photodiode has a reverse bias capacitance which is far smaller than that of the sandwich PIN photodiode.

If the reverse bias capacitance is small, only a small amount of photo current causes the terminal voltage of the reverse bias capacitance C_{H} to be a maximum. In other words, the reverse bias capacitance is saturated with a small amount of photo current, which causes the dynamic range to be very narrow. Moreover, the holding characteristic, which determines how long a signal can be held, becomes short, which is not a desirable characteristic for a photosensor.

Patent Abstracts of Japan, volume 9, No. 35 (E-296) (1758), 14 February 1985 discloses an image-sensor comprising a photodiode and a capacitance connected in parallel with the photodiode to increase the charge storage capacitance.

According to the present invention there is provided a photosensor comprising:
a lateral PIN photodiode formed of a P type semiconductor layer, an intrinsic semiconductor layer and an N type semiconductor layer arranged in parallel on an insulating substrate;
characterized by:
a capacitor formed of a first electrode, said first electrode being a semiconductor layer located on said insulating substrate and formed integrally with and connected to one of said P type or N type semiconductor layers, an insulating layer covering at least a part of said first electrode, and a second electrode formed over said first electrode being separated therefrom by said insulating layer and connected to the other one of said P type or N type semiconductor layers, said capacitor being in parallel with the internal capacitance of said lateral PIN photodiode.

The invention will now be described by way of example with reference to the accompanying drawings, throughout which like parts are referred to by like references, and in which:
Figure 1 is a cross-sectional view showing a previously proposed photosensor;
Figure 2 is a schematic circuit diagram showing an equivalent circuit of a PIN photodiode;
Figure 3 is a schematic circuit diagram showing a photo detecting circuit ;
Figure 4 is a characteristic graph showing the output voltage of the previously proposed PIN photodiodes in a dark field;

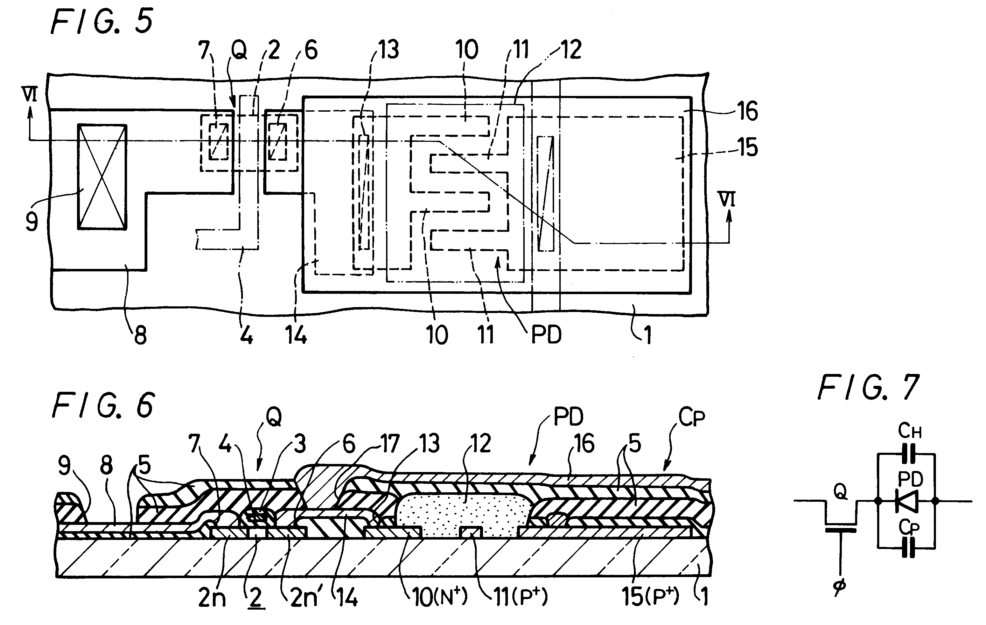

Figure 5 is a plan view showing patterns of respective layers of a first embodiment of photosensor according to the present invention with an insulating layer removed;
Figure 6 is a cross-sectional view taken along a line VI-VI of Figure 5;
Figure 7 is a schematic diagram showing a photo detecting circuit;

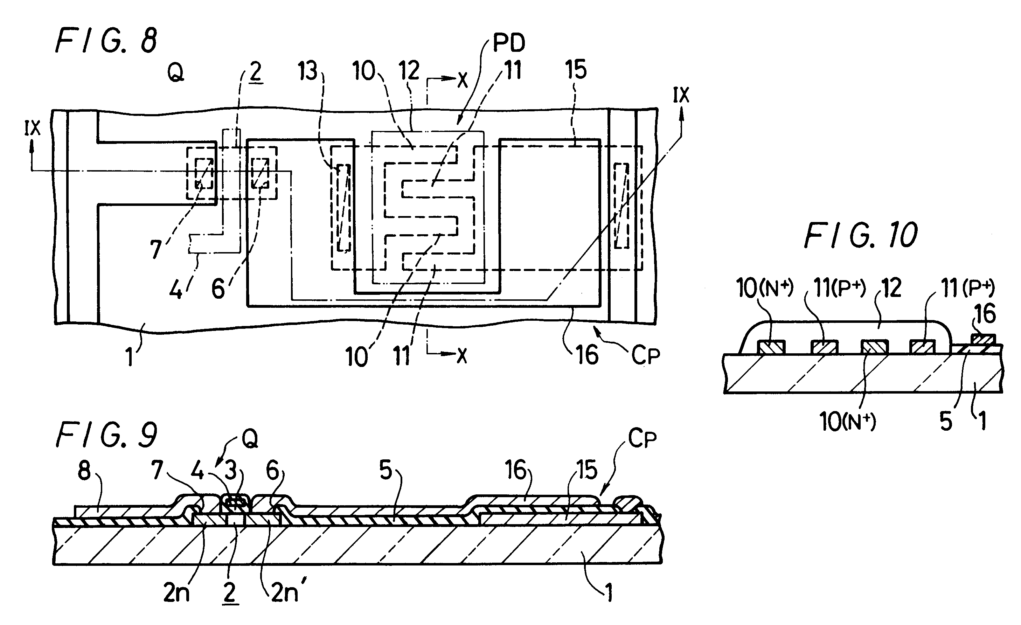

Figure 8 is a plan view showing patterns of respective layers of a second embodiment of photosensor according to the present invention;
Figure 9 is a cross-sectional view taken along a line IX-IX of Figure 8; and
Figure 10 is a cross-sectional view taken along a line X-X in Figure 8.

The first embodiment of photosensor, shown in Figures 5 to 7, comprises a transparent insulating substrate 1 made for example of glass carrying a semiconductor layer 2 which is formed with a drain, a channel and a source of an N channel MOS transistor Q. N channel regions form a drain 2n and a source 2n'. An insulating layer 3 is the gate of the MOS transistor Q. A silicon gate electrode 4 and an insulating layer 5 are also shown. A window portion 6 for forming a source electrode, and a window portion 7 for forming a drain electrode are shown. A wiring layer 8 made of aluminium is connected to the drain 2n through the window portion 7, and a window portion 9 is the bonding pad of the wiring layer 8.

An N⁺ type semiconductor layer 10 and a P⁺ type semiconductor layer 11 forming a PIN photodiode PD are formed in comb shapes. The layers 10 and 11 are located so that as shown in Figure 5 they have interdigital projections which are intermeshed as shown with constant distances between them. The layers 10 and 11 are thus formed and arranged so that the ratio of the facing areas to the area occupied is increased, thereby to provide a larger photo current and consequently increase the sensitivity.

An amorphous intrinsic (I) semiconductor thin layer 12 is formed in a portion above and between the layers 10 and 11. The layers 12, 10 and 11 form the PIN photodiode PD. A window portion 13 allows the surface of the N⁺ type layer 10 to be exposed. A wiring layer 14 made of aluminium is connected, at one end portion thereof, with the surface of the source of the MOS transistor Q through the window portion 6, and, at the other end portion with the surface of the N⁺ type layer 10, through the window portion 13. Thus, the wiring layer 14 serves serially to connect the MOS transistor Q with the PIN photodiode PD.

A P⁺ type semiconductor layer 15 is formed integrally and simultaneously with the P⁺ type layer 11, and is rectangular in shape. A wiring layer 16 made of aluminium has one end connected to the surface of the wiring layer 14 through a window portion 17, and the other end extends over the surface of the insulating layer 5 on the I layer 12 to a position so as to oppose the P⁺ type layer 15 through the insulating layer 5. Thus, the P⁺ type layer 15 and the wiring layer 16 which faces it through the insulating layer 5 form a capacitor C_{P}. The capacitor C_{P} is connected in parallel with the photodiode PD, so that a photo detecting circuit as shown in Figure 7 exists.

The photodiode PD has an inherent reverse bias capacitance C_{H} and the capacitor Cp formed of the wiring layer 16 and the P⁺ type layer 15 are connected in parallel therewith so as to compensate for the small inherent reverse bias capacitance C_{H} of the photodiode PD. It is therefore possible to increase the dynamic range, which would have been small due to the insufficient capacitance C_{H}, and thus to improve the signal holding characteristic. Specifically, due to the capacitor C_{P}, the effective reverse bias capacitance of the lateral PIN photodiode PD can be increased relative to that of the sandwich PIN photodiode, as shown by the dashed line in Figure 4.

Since the wiring layer 16 made of aluminium is arranged to pass over the I layer 12, the photo converting efficiency of the photodiode PD will also be increased. That is, since aluminium is reflecting and is arranged above the I layer 12 which effects photo-electric conversion, even if a portion of the incident light on the I layer 12 passes through the I layer 12, such portion is reflected by the wiring layer 16 so as to be returned to the I layer 12 where it is subjected to photo-electric conversion. Thus, the light incident on the I layer 12 is substantially all photo-electrically converted, which makes the photo-electric converting efficiency substantially higher.

An electrode is connected to either one of the P type layer 11 or the N type layer 10, and another electrode is arranged on the abovementioned electrode through the insulating layer 5 and is connected to the other one of the P type layer 11 or the N type layer 10. Thus, since a capacitor is connected in parallel with the reverse bias capacitance of the PIN photodiode PD, the reverse bias capacitance is substantially increased, and the dynamic range becomes wider, and accordingly the photodetecting signal holding characteristic is improved.

A second embodiment of the present invention will now be described with reference to Figures 8 to 10. The aluminium wiring layer 14 is formed simultaneously with the wiring layer 8 and is connected to the source of the MOS transistor Q through the window portion 6, and to the surface of the N⁺ type layer 10 through the other window portion 13. The wiring layer 16 by-passes the PIN photodiode PD, and is formed on the P⁺ type layer 15 through the insulating layer 5. The portion of the wiring layer 16 by-passing the photodiode PD is made narrow, and the portion over the P type layer 15 is made wider so that it faces the P type layer 15.

As described above, the capacitor C_{P} is formed of the P⁺ type layer 15 and the wiring layer 16 which faces the P type layer 15 through the insulating layer 5. The capacitor C_{P} is connected in parallel with the photodiode PD and forms the photo detecting circuit as shown in Figure 7.

Thus, in the same manner as the first embodiment, the PIN photodiode PD has an inherent reverse bias capacitance C_{H}, and the capacitor C_{P} formed of the wiring layer 16 and the P⁺ type layer 15 is connected in parallel therewith, so as to compensate for the small amount of capacitance of the inherent reverse bias capacitance C_{H} of the photodiode PD. It is therefore possible to increase the capacitance in the dynamic range and compensate for the small capacitance of the reverse bias capacitance, and accordingly improve the signal holding characteristic. Specifically, due to the capacitor C_{P}, the effective reverse bias capacitance of the photodiode PD is increased to that of the sandwich PIN photodiode as shown by the dashed line in Figure 4.

Since the P⁺ type layer 15 which forms one of the electrodes of the capacitor C_{P} is formed integrally with the P⁺ type layer 11, and the wiring layer 16 forming the other electrode is formed simultaneously with the wiring layer 8, it is not necessary to provide an additional step in the process for forming the capacitor C_{P}. Thus the manufacturing process remains simple and inexpensive.

Thus, since the photosensor of the second embodiment has a capacitor connected in parallel with the reverse bias capacitance of the PIN photodiode, the total reverse bias capacitance is substantially increased, the dynamic range becomes wider, and consequently the photodetecting signal holding characteristic is improved.

Moreover, the capacitor has one of its electrode formed during the process for forming one of the P or N type layers constituting the PIN photodiode, and the other electrode is formed during the process for forming the wiring layer which is electrically connected to the other semiconductor layer. It is therefore possible to form the capacitor without making the manufacturing process of the photosensor more complicated, thereby improving the characteristics, such as widening the dynamic range, without increasing the manufacturing costs.

## Claims

1. A photosensor comprising:
a lateral PIN photodiode (PD) formed of a P type semiconductor layer (11), an intrinsic semiconductor layer (12) and an N type semiconductor layer (10) arranged in parallel on an insulating substrate (1);
characterized by:
a capacitor (Cp) formed of a first electrode (15), said first electrode (15) being a semiconductor layer located on said insulating substrate (1) and formed integrally with and connected to one of said P type or N type semiconductor layers (11, 10), an insulating layer (5) covering at least a part of said first electrode (15), and a second electrode (16) formed over said first electrode (15) being separated therefrom by said insulating layer (5) and connected to the other one of said P type or N type semiconductor layers (11, 10), said capacitor (Cp) being in parallel with the internal capacitance (C_{H}) of said lateral PIN photodiode (PD).

2. A photosensor according to claim 1 wherein said second electrode (16) is a wiring layer (16) which is connected to a surface of the other one of said P type or N type semiconductor layers (11, 10) through a window portion (17) which is formed through said insulating layer (5).

## Patentansprüche

1. Fotodetektor mit:
einer lateralen PIN-Fotodiode (PD), die aus einer Halbleiterschicht (11) vom P-Typ, einer eigenleitenden Halbleiterschicht (12) und einer Halbleiterschicht (10) vom N-Typ gebildet ist, welche parallel auf einem isolierenden Substrat (1) angeordnet sind;
gekennzeichnet durch:
einen von einer ersten Elektrode (15) gebildeten Kondensator (Cp), wobei die erste Elektrode (15) eine Halbleiterschicht ist, welche auf dem isolierenden Substrat (1) angeordnet ist und als eine Einheit und verbunden mit einer der Halbleiterschichten (11, 10) vom P-Typ oder N-Typ ausgebildet ist, eine Isolierschicht (5), welche mindestens einen Teil der ersten Elektrode (15) bedeckt, und eine zweite Elektrode (16), welche über der ersten Elektrode (15) von dieser durch die Isolierschicht (5) getrennt ausgebildet ist und mit der anderen der Halbleiterschichten (11, 10) vom P-Typ oder N-Typ verbunden ist, wobei der Kondensator (Cp) parallel zur inneren Kapazität (C_{H}) der lateralen PIN-Fotodiode (PD) liegt.

2. Fotodetektor nach Anspruch 1, bei dem die zweite Elektrode (16) eine Leitungsführungsschicht (16) ist, welche mit einer Oberfläche der anderen der Halbleiterschichten (11, 10) vom P-Typ oder N-Typ über einen Fensterbereich (17) verbunden ist, welcher durch die Isolierschicht (5) hindurch ausgebildet ist.

## Revendications

1. Photocapteur comprenant:
une photodiode PIN latérale (PD) formée d'une couche de semi-conducteur de type P (11), d'une couche de semi-conducteur intrinsèque (12) et d'une couche de semi-conducteur de type N (10) disposées en parallèle sur un substrat isolant (1), caractérisé par:
un condensateur (Cp) formé d'une première électrode (15), ladite première électrode (15) étant une couche de semi-conducteur placée sur ledit substrat isolant (1), formée intégralement et connectée avec l'une desdites couches de semi-conducteur de type N et de type P (10,11),d'une couche isolante (5) recouvrant au moins une partie de ladite première électrode (15), et d'une seconde électrode (16) formée au dessus de ladite première électrode (15), séparée de celle-ci par ladite couche isolante (5) et reliée à l'autre desdites couches de semi-conducteur de type N et de type P (11,10), ledit condensateur (Cp) étant en parallèle avec la capacité interne (C_{H}) de ladite photodiode PIN latérale (PD).

2. Photocapteur selon la revendication 1 dans lequel ladite seconde électrode (16) est une couche de connexion (16) qui est reliée à une surface de l'autre desdites couches de semi-conducteur de type N ou de type P (11,10) à travers une partie fenêtre (17) qui est formée à travers ladite couche isolante (5).
